# DEMANDE DE BREVET EUROPEEN

(11) **EP 1 289 024 A1**
(43) Date de publication de la demande: **05.03.2003**
(21) Numéro de dépôt: 02292109.2
(22) Date de dépôt: 28.08.2002
(51) Int. Cl.: H01L 29/788

(54) **Cellule mémoire du type FAMOS à plusieurs niveaux logiques de programmation**

(30) Priorité: 03.09.2001 FR 0111381
(71) Demandeur: STMicroelectronics S.A., 92120 Montrouge (FR)
(72) Inventeur: Dray, Cyrille, 38100 Grenoble (FR); Caspar, Daniel, 38660 Saint Hilaire du Touvet (FR); Fournel, Richard, 38660 Lumbin (FR)
(74) Mandataire: Casalonga, Axel

(57) **Abrégé**

Le point mémoire de type FAMOS comporte une unique grille flottante GR chevauchant une surface active d'un substrat semiconducteur selon au moins deux profils de chevauchement dissymétriques PF1 ,PF2 de façon à délimiter au moins deux électrodes sur la zone active. Des moyens de programmation du point mémoire MC,SW sont aptes à appliquer sélectivement des jeux différents de tensions de polarisation prédéterminées sur les électrodes de façon à conférer au moins trois niveaux logiques de programmation au point mémoire.

## Description

L'invention concerne les circuits intégrés, et plus particulièrement les cellules mémoire ou points mémoire de type FAMOS, c'est-à-dire basés sur un transistor de type FAMOS.

On rappelle que la technologie FAMOS, acronyme anglais de "Floating gate Avalanche injection MOS", utilise le point mémoire obtenu avec un transistor MOS de type P dont l'unique grille est isolée (c'est-à-dire non connectée électriquement).

Cette grille unique est donc flottante.

Ce point mémoire peut être obtenu sans ajouter d'étapes supplémentaires au procédé technologique de base de fabrication d'un transistor MOS de type P. Contrairement aux autres points mémoire, par exemple de type FLASH, EPROM ou EEPROM, qui comprennent une grille flottante et une grille de commande, la cellule mémoire de type FAMOS ne comprend qu'une seule grille flottante.

Pour effacer un point mémoire de type FAMOS, on peut recourir aux rayons ultraviolets. Dans ce cas, ce type de point mémoire est plus particulièrement utilisé comme mémoire programmable une seule fois, dite "mémoire OTP".

Actuellement, la configuration d'une cellule mémoire de type FAMOS s'appuie sur un transistor linéaire, c'est-à-dire présentant une grille rectangulaire chevauchant une zone active et définissant ainsi les deux électrodes source et drain du transistor. Le point mémoire est donc parfaitement symétrique, et ses caractéristiques électriques en programmation et en lecture sont indifférentes au sens de branchement du transistor.

La seule possibilité offerte alors pour disposer de plusieurs niveaux de programmation, et donc de lecture, par exemple quatre niveaux de programmation, soit 2 bits/cellule mémoire, est d'effectuer un contrôle fin du temps de programmation, ce qui va permettre d'injecter plus ou moins de charges dans la grille flottante.

Or, un tel procédé est extrêmement délicat à mettre en oeuvre et nécessite un asservissement critique afin de garantir une fenêtre temporelle de programmation compatible avec la performance du circuit de lecture.

L'invention a pour but de proposer un point mémoire de type FAMOS, capable de présenter au moins trois niveaux de programmation, voire plus, totalement naturels, c'est-à-dire qui sont uniquement liés aux caractéristiques physiques du point mémoire et aux différentes tensions de polarisation appliquées mais tout en étant indépendants de la durée d'application de ces tensions de polarisation au delà d'une certaine durée de saturation, typiquement de l'ordre de 1 ms. En fait, selon l'invention, le point mémoire va atteindre naturellement et de lui-même au delà de cette durée de saturation, un équilibre correspondant à un niveau de programmation, en fonction simplement des tensions de polarisation appliquées.

L'invention propose donc un dispositif de mémoire, comprenant un point mémoire de type FAMOS, comportant une unique grille flottante chevauchant une surface active d'un substrat semiconducteur selon au moins deux profils de chevauchement dissymétriques de façon à délimiter au moins deux électrodes sur la zone active. Par ailleurs, le dispositif comprend des moyens de programmation du point mémoire aptes à appliquer sélectivement des jeux différents de tension de polarisation prédéterminés sur les électrodes, de façon à conférer au moins trois niveaux logiques de programmation au point mémoire.

Le point mémoire FAMOS selon l'invention, présente donc une configuration asymétrique. Il devient donc possible de créer "naturellement" plusieurs niveaux distincts de programmation selon les tensions de polarisation appliquées sur les différentes électrodes. Au bout d'un certain temps, le point mémoire atteint de lui-même son équilibre en ce qui concerne la quantité de charges injectées dans la grille, ce qui permet de définir un niveau logique de programmation.

Par ailleurs, une telle cellule FAMOS selon l'invention ne nécessite aucune modification du process de fabrication CMOS classique, notamment au niveau des implantations. Seule la géométrie de la grille permet, en combinaison avec des jeux de tensions de polarisation différents, l'obtention des différents niveaux de programmation. En d'autres termes, le point mémoire selon l'invention est directement compatible avec un process logique CMOS qui par nature n'est pas prévu pour la réalisation de cellules mémoire non volatiles.

Selon un mode de réalisation de l'invention, la grille flottante chevauche la surface active selon deux profils de chevauchement dissymétriques de façon à délimiter deux électrodes. C'est notamment le cas lorsque la grille présente une configuration annulaire.

L'un des trois niveaux logiques de programmation correspond par exemple à un point mémoire effacé, les moyens de programmation n'appliquant alors aucune tension de polarisation sur les électrodes du point mémoire.

Par ailleurs, pour conférer au point mémoire un deuxième niveau logique de programmation, les moyens de programmation définissent par exemple une première électrode comme étant le drain du transistor du point mémoire, et la deuxième électrode comme étant la source du transistor, et appliquent des premières tensions de polarisation prédéterminées correspondantes de source et de drain.

Pour conférer au point mémoire un troisième niveau logique de programmation, les moyens de programmation définissent par exemple la première électrode comme étant la source du transistor du point mémoire, et la deuxième électrode comme étant le drain du transistor, et appliquent des deuxièmes tensions de polarisation prédéterminées correspondantes.

En pratique, les moyens de programmation peuvent par exemple appliquer dans le premier cas une tension de 0 volt sur la première électrode et de 5 volts sur la deuxième électrode, et appliquer dans le deuxième cas une tension de 5 volts sur la première électrode et de 0 volt sur la deuxième électrode.

Lorsque la grille présente une configuration annulaire, la première électrode peut être définie comme étant l'électrode centrale située à l'intérieur de la grille, tandis que la deuxième électrode peut être définie comme étant l'électrode périphérique située à l'extérieur de la grille.

Selon un autre mode de réalisation de l'invention, la grille flottante présente une configuration en forme de 8 délimitant une électrode périphérique située à l'extérieur de la grille, une première électrode centrale située à l'intérieur d'une première boucle du 8, et une deuxième électrode centrale située à l'intérieur de la deuxième boucle du 8. Les moyens de programmation du point mémoire sont alors aptes à appliquer sélectivement des jeux différents de tensions de polarisation prédéterminées sur les électrodes de façon à conférer plus de trois niveaux logiques de programmation au point mémoire, par exemple quatre, voire plus.

A cet égard, les moyens de programmation peuvent définir l'une des trois électrodes comme étant le drain du transistor du point mémoire, une autre des trois électrodes comme étant la source du transistor, et la troisième électrode comme étant une électrode de contrôle. Les moyens de programmation sont alors aptes par exemple à appliquer des tensions de polarisation correspondantes sur la source et sur le drain et à appliquer sélectivement sur l'électrode de contrôle des tensions différentes comprises entre la tension de source et la tension de drain, de façon à obtenir respectivement différents niveaux logiques de programmation.

Bien entendu, il est également possible, pour obtenir encore plus de niveaux logiques de programmation, d'inverser la source et le drain.

Il est également possible que l'un des niveaux logiques de programmation corresponde à un point mémoire effacé, les moyens de programmation n'appliquant alors aucune tension de polarisation sur les électrodes du point mémoire.

A titre d'exemple, l'électrode périphérique peut correspondre à la source du transistor et le drain correspondre à l'une des deux électrodes centrales.

Le dispositif selon l'invention comprend également avantageusement des moyens de lecture des niveaux logiques de programmation qui sont aptes à appliquer des tensions de polarisation spécifiques sur la source et sur le drain du transistor du point mémoire, de façon à permettre une mesure du courant de drain.

Un courant de drain plus important sera avantageusement obtenu lorsque la source est considérée en lecture comme étant l'électrode périphérique.

L'invention a également pour objet un circuit intégré comportant au moins un dispositif de mémoire tel que défini ci-avant.

D'autres avantages et caractéristiques de l'invention apparaîtront à l'examen de la description détaillée de modes de réalisation nullement limitatifs et des dessins annexés, sur lesquels :
- la figure 1 illustre un premier mode de réalisation d'un dispositif de mémoire selon l'invention; et
- la figure 2 illustre un deuxième mode de réalisation d'un point mémoire selon l'invention.

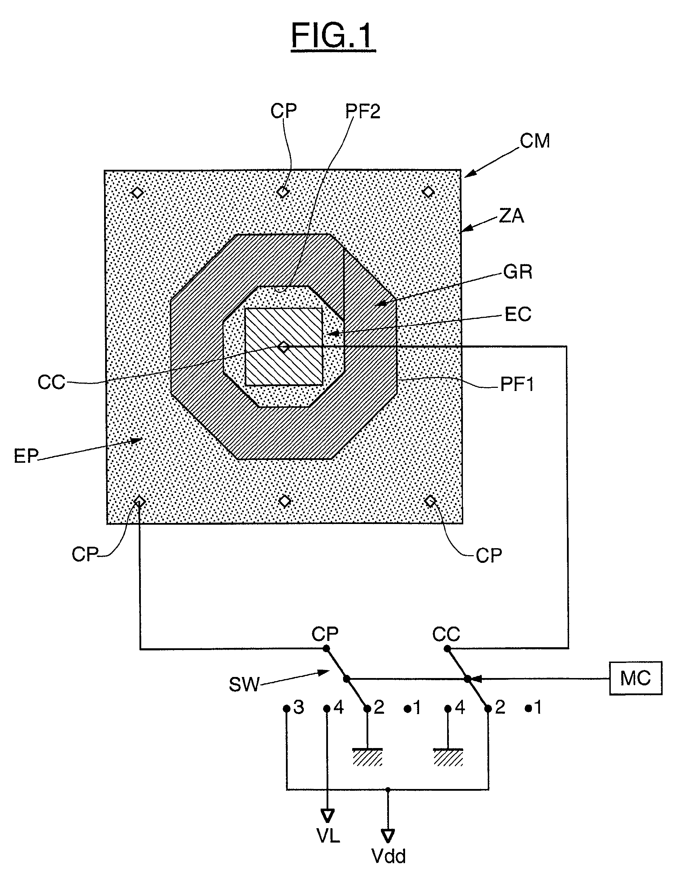

Sur la figure 1, la référence CM désigne un point mémoire de type FAMOS. Ce point mémoire comporte sur une zone active ZA d'un substrat de silicium, entourée d'une zone d'isolement (non représentée ici à des fins de simplification), par exemple du type "tranchée peu profonde", une grille GR d'un transistor PMOS. Cette grille GR est une grille flottante, c'est-à-dire qu'elle n'est pas connectée électriquement. Elle repose sur la zone active par l'intermédiaire d'une couche d'oxyde de grille, par exemple du dioxyde de silicium.

La grille GR a une configuration annulaire et elle chevauche par conséquent la zone active selon deux profils dissymétriques, à savoir un profil (pourtour) extérieur PF1 qui est plus long que le pourtour interne PF2.

La grille GR définit donc dans la zone active une première électrode centrale EC et une deuxième électrode périphérique EP. Un plot de contact CC est disposé sur l'électrode centrale EC pour recevoir une tension de polarisation. Par ailleurs, l'électrode périphérique est pourvue de plusieurs plots de contact CP pour recevoir également une tension de polarisation.

En raison du caractère dissymétrique des profils de chevauchement PF1 et PF2, la capacité de couplage grille/électrode centrale est plus faible que la capacité de couplage grille/électrode périphérique.

C'est cette caractéristique qui, combinée à des jeux de tension de polarisation différents, vont permettre d'obtenir plusieurs niveaux naturels de programmation pour le point mémoire CM.

Sur la figure 1, on a représenté les moyens de programmation sous la forme très schématique d'un commutateur SW commandé par des moyens de commande MC et capable de prendre différentes positions, permettant de conférer différents jeux de tensions de polarisation sur les contacts des électrodes du point mémoire. Matériellement, ces moyens de programmation peuvent être aisément réalisés par l'homme du métier sous la forme de circuits logiques comportant des portes et des multiplexeurs par exemple.

Un premier niveau de programmation est obtenu avec un point mémoire effacé. Dans ce cas, aucune tension de polarisation n'est appliquée sur les électrodes du point mémoire et les deux branches du commutateur SW se situent sur les points 1.

Un deuxième niveau de programmation est obtenu en plaçant les deux branches du commutateur SW sur les points 2. De ce fait, le contact CC de l'électrode centrale est relié à la tension d'alimentation Vdd, par exemple +5 volts, tandis que le contact CP de l'électrode périphérique est relié à la masse.

Dans une telle configuration, l'électrode périphérique EP est alors le drain du transistor PMOS, tandis que l'électrode centrale est la source du transistor PMOS.

Le troisième niveau de programmation est obtenu en reliant le contact CP au point 3 et en reliant le contact CC au point central 2 qui est connecté à la masse. Dans ce cas, c'est l'électrode centrale EC qui fait office de drain et l'électrode périphérique qui fait office de source.

En raison de la différence de capacité de couplage grille/source et grille/drain, la quantité de charges injectées dans la grille sera plus élevée lorsque le drain est au centre que lorsque le drain est en périphérie.

La lecture des niveaux logiques de programmation s'effectue en appliquant une tension spécifique de lecture source/drain Vds, typiquement de l'ordre de -1 volt. On veillera en effet à ne pas dépasser un seuil de tension trop élevé de façon à ne pas programmer de façon indésirée le point mémoire. Ainsi, à titre indicatif, on choisira une tension de source égale à 0 volt et une tension de drain égale à -1 volt.

La lecture peut s'effectuer en choisissant la source comme électrode périphérique et le drain comme électrode centrale ou l'inverse. Cependant, pour obtenir un courant de drain plus important, il est avantageux de choisir en lecture le drain comme électrode périphérique. En effet, la tension de drain étant inférieure à la tension de source, on va tirer le potentiel de la grille vers un potentiel négatif puisque la grille suit préférentiellement le potentiel de l'électrode périphérique. En conséquence, la tension grille/source est plus importante dans cette configuration que la tension grille/source qui serait obtenue avec un drain pris au niveau de l'électrode centrale. Il en résulte donc une conduction plus importante du transistor et par conséquent un courant de drain plus important.

Sur la figure 1, la lecture est effectuée en commandant le commutateur SW de façon à connecter le contact CP au point 4 qui est relié à la tension VL égale à -1 volt, et de façon à relier le contact CC à l'autre point 4 qui est relié à la masse. De ce fait, le drain est donc en périphérie dans le mode de lecture.

Le niveau du courant de drain mesuré va permettre de différencier les trois niveaux de programmation. Plus précisément, lorsque la cellule mémoire était dans l'état effacé, le transistor PMOS est bloqué, ce qui conduit à l'obtention d'un courant de drain de l'ordre de quelques picoampères. Le courant de drain sera de l'ordre de la centaine de µA lorsque la cellule mémoire a été programmée avec la source au centre et le drain en périphérie. Ce courant de drain sera plus important, par exemple trois fois plus important lorsque la cellule mémoire a été programmée avec le drain au centre et la source en périphérie.

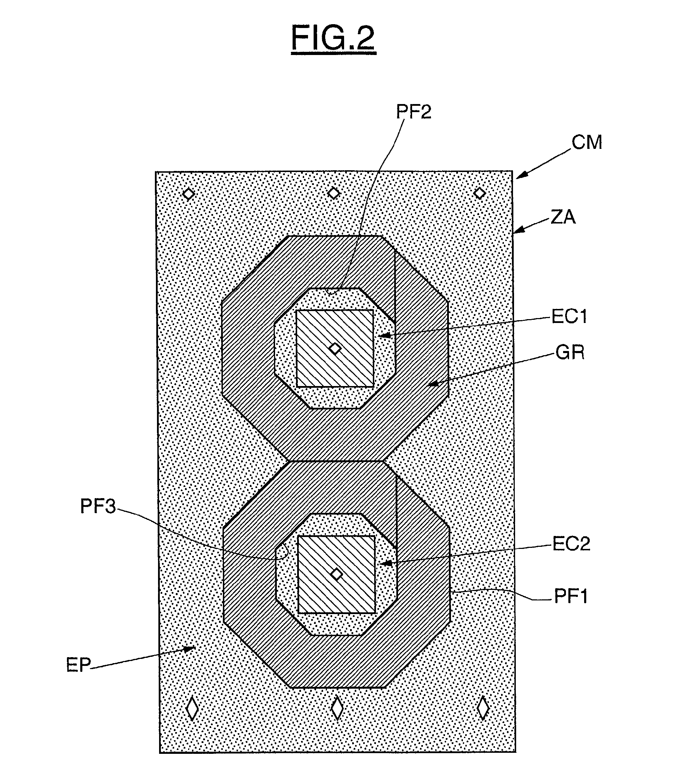

Dans le mode de réalisation de la figure 2, la grille présente une configuration en 8. Elle chevauche par conséquent la zone active ZA selon trois profils de chevauchement PF1, PF2 et PF3. Le profil de chevauchement externe est différent des deux profils de chevauchement internes PF2 et PF3 correspondant respectivement aux pourtours internes des deux boucles du 8.

La grille flottante délimite ainsi une électrode périphérique EP située à l'extérieur de la grille GR, une première électrode centrale EC1 située à l'intérieur d'une première boucle du 8, et une deuxième électrode centrale EC2 située à l'intérieur de la deuxième boucle du 8.

On peut alors définir par exemple l'électrode centrale EC1 comme étant le drain du transistor PMOS et l'électrode périphérique EP comme étant la source du transistor PMOS. La deuxième électrode centrale EC2 est alors considérée comme étant une électrode de contrôle.

Plus précisément, pour la programmation de la cellule-mémoire, on appliquera par exemple 5 volts sur la source, 0 volt sur le drain. Ceci va conduire à un premier niveau logique de programmation.

Puis, on pourra appliquer sélectivement plusieurs valeurs différentes de tension de polarisation sur l'électrode de contrôle EC2, cette tension de polarisation étant comprise entre la tension de source et la tension de drain. Chaque valeur de la tension de contrôle va modifier la quantité de charges injectées dans la grille et par conséquent conférer un état logique de programmation différent. On peut donc aisément obtenir quatre niveaux de programmation.

Le nombre de niveaux de programmation peut encore être augmenté en combinant l'utilisation de cette tension de contrôle avec l'inversion de polarité des tensions de source et de drain, de façon à définir le drain en périphérie et la source dans la première boucle du 8.

Bien entendu, comme dans le mode de réalisation précédent, un des niveaux logiques de programmation peut correspondre à un point mémoire effacé, les moyens de programmation n'appliquant alors aucune tension de polarisation sur les électrodes du point mémoire.

En ce qui concerne la lecture des niveaux de programmation de cette cellule mémoire CM, elle s'effectue d'une façon analogue à celle qui a été décrite ci-avant pour le mode de réalisation précédent.

Quelle que soit la variante de réalisation utilisée, la cellule mémoire peut être associée sur un circuit intégré de façon matricielle à plusieurs autres cellules mémoire analogues. On obtient alors un plan mémoire particulièrement compact en terme de nombre de cellules et qui offre un nombre élevé de combinaisons possibles de codage.

L'invention n'est pas limitée aux modes de réalisation qui viennent d'être décrits mais en embrasse toutes les variantes. Ainsi, il est possible d'envisager tout autre profil asymétrique de chevauchement de la grille. Cependant un profil annulaire est avantageux car il permet une meilleure rétention des données mémorisées sans modifier le profil des régions d'isolement entourant la zone active.

## Revendications

1. Dispositif de mémoire, comprenant un point mémoire de type FAMOS comportant une unique grille flottante (GR) chevauchant une surface active d'un substrat semiconducteur selon au moins deux profils de chevauchement dissymétriques (PF1,PF2) de façon à délimiter au moins deux électrodes sur la zone active, et des moyens de programmation du point mémoire (MC,SW) aptes à appliquer sélectivement des jeux différents de tensions de polarisation prédéterminées sur les électrodes de façon à conférer au moins trois niveaux logiques de programmation au point mémoire.

2. Dispositif selon la revendication 1, **caractérisé par le fait que** la grille flottante chevauche ladite surface active selon deux profils de chevauchement dissymétriques (PF1,PF2) de façon à délimiter deux électrodes, **par le fait que** l'un des trois niveaux logiques de programmation correspond à un point mémoire effacé, les moyens de programmation n'appliquant alors aucune tension de polarisation sur les électrodes du point mémoire, **par le fait que** pour conférer au point mémoire un deuxième niveau logique de programmation, les moyens de programmation définissent une première électrode comme étant le drain du transistor du point mémoire, et la deuxième éléctrode comme étant la source du transistor, et appliquent des premières tensions de polarisation prédéterminées correspondantes, et **par le fait que** pour conférer au point mémoire un troisième niveau logique de programmation, les moyens de programmation définissent la première électrode comme étant la source du transistor du point mémoire, et la deuxième éléctrode comme étant le drain du transistor, et appliquent des deuxièmes tensions de polarisation prédéterminées correspondantes.

3. Dispositif selon la revendication 2, **caractérisé par le fait que** la grille (GR) présente une configuration annulaire définissant la première électrode comme étant l'électrode centrale située à l'intérieur de la grille, et la deuxième électrode comme étant l'électrode périphérique située à l'extérieur de la grille.

4. Dispositif selon la revendication 1, **caractérisé par le fait que** la grille flottante (GR) présente une configuration en forme de 8 délimitant une électrode périphérique (EP) située à l'extérieur de la grille, une première électrode centrale (EC1) située à l'intérieur d'une première boucle du 8, et une deuxième électrode centrale(EC2) située à l'intérieur de la deuxième boucle du 8, et **par le fait que** les moyens de programmation du point mémoire sont aptes à appliquer sélectivement des jeux différents de tensions de polarisation prédéterminées sur les électrodes de façon à conférer plus de trois niveaux logiques de programmation au point mémoire.

5. Dispositif selon la revendication 4, **caractérisé par le fait que** les moyens de programmation définissent l'une (EC1) des trois électrodes comme étant le drain du transistor du point mémoire, une autre (EP) des trois éléctrodes comme étant la source du transistor, et la troisième électrode (EC2) comme étant une électrode de contrôle, et **par le fait que** les moyens de programmation sont aptes à appliquer des tensions de polarisation correspondantes sur la source et sur le drain et à appliquer sélectivement sur l'électrode de contrôle des tensions différentes comprises entre la tension de source et la tension de drain, de façon à obtenir respectivement différents niveaux logiques de programmation.

6. Dispositif selon la revendication 4 ou 5, **caractérisé par le fait que** l'un des niveaux logiques de programmation (MC,SW) correspond à un point mémoire effacé, les moyens de programmation n'appliquant alors aucune tension de polarisation sur les électrodes du point mémoire.

7. Dispositif selon l'une des revendications 4 à 6, **caractérisé par le fait que** l'électrode périphérique (EP) correspond à la source du transistor, et le drain correspond à l'une des deux électrodes centrales.

8. Dispositif selon l'une des revendications précédentes, **caractérisé par le fait qu'**il comprend des moyens de lecture (MC,SW) des niveaux logiques de programmation, aptes à appliquer des tensions de polarisation spécifiques sur la source et sur le drain du transistor du point mémoire de façon à permettre une mesure du courant de drain.

9. Dispositif selon la revendication 8 prise en combinaison avec la revendication 3 ou l'une des revendications 4 à 7, **caractérisé par le fait que** les moyens de lecture définissent la source comme étant l'électrode périphérique.

10. Circuit intégré, **caractérisé par le fait qu'**il comporte au moins un dispositif de mémoire selon l'une des revendications 1 à 9.
